# EUROPEAN PATENT SPECIFICATION

(11) **EP 2 267 537 B1**
(45) Date of publication and mention of the grant of the patent: **13.09.2017**
(21) Application number: 10180309.6
(22) Date of filing: 26.10.2004
(51) Int. Cl.: G03F 7/20

(54) **Lithographic apparatus**
Lithographischer Apparat
Appareil lithographique

(30) Priority: 28.10.2003 EP 03256820
(43) Date of publication of application: 29.12.2010
(62) Divisional of application: 04256585.3
(73) Proprietor: ASML Netherlands BV, 5504 DR Veldhoven (NL)
(72) Inventor: Hoogendam Christiaan, 5563 AR, Westerhoven (NL); Bijlaart, Erik, 5247 XM, Rosmalen (NL); Kolesnychenko, Aleksey, 5701 EE, Helmond (NL); Loopstra, Erik, 5613 ES, Eindhoven (NL); Mertens, Jeroen, 5511 AM, Knegsel (NL); Mulkens, Johannes, 5552 MA, Valkenswaard (NL); Slaghekke, Bernardus, 5502 PB, Veldhoven (NL); Streefkerk, Bob, 5038 PE, Tilburg (NL); Tinnemans, Patricius, 5527GR, Hapert (NL); Van Santen, Helmar, 1019 PW, Amsterdam (NL)
(74) Representative: Corcoran, Gregory Martin Mason

(56) References cited:
- EP-A- 0 605 103
- EP-A- 0 834 773
- EP-A- 1 420 302
- EP-A- 1 482 372
- EP-A- 1 494 079
- EP-A2- 1 498 781
- WO-A-99/49504
- WO-A-2004/055803
- WO-A-2005/015315
- JP-A- 63 157 419
- JP-A- 2003 297 735

## Description

### Field

The present invention relates to a lithographic apparatus.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.) Other immersion liquids have been proposed, including water with solid particles (e.g. quartz) suspended therein. However, submersing the substrate or substrate and substrate table in a bath of liquid (see for example US 4, 509, 852) means that there is a large body of liquid that must be accelerated during a scanning exposure. This requires additional or more powerful motors and turbulence in the liquid may lead to undesirable and unpredictable effects.

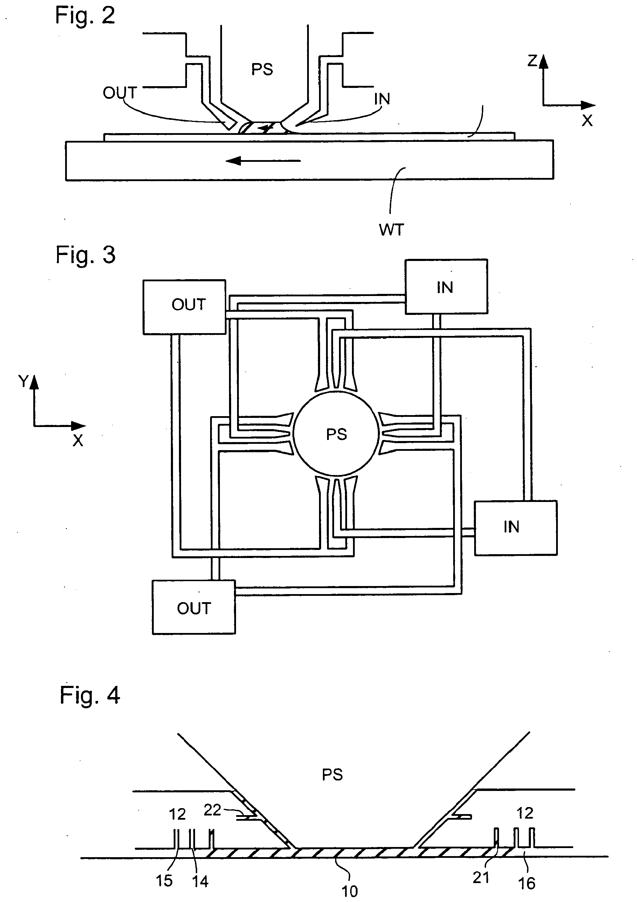

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a - X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

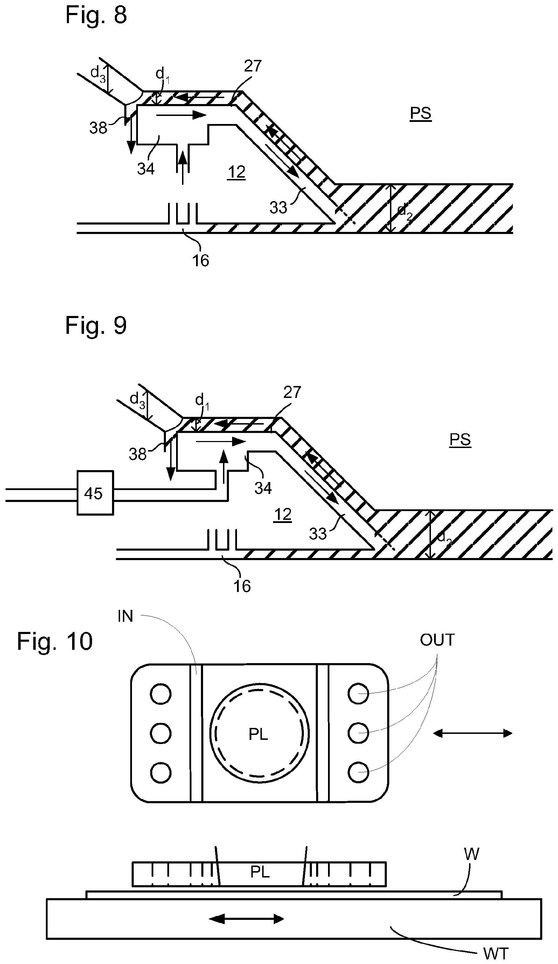

Another solution which has been proposed is to provide the liquid supply system with a seal member which extends along at least a part of a boundary of the space between the final element of the projection system and the substrate table. Such a solution is illustrated in Figure 10. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such as system with a gas seal is disclosed in European Patent Application No. 03252955.4. In European Patent Application No. 03257072.3 the idea of a twin or dual stage immersion lithography apparatus is disclosed. Such an apparatus is provided with two stages for supporting the substrate. Leveling measurements are carried out with a stage at a first position, without immersion liquid, and exposure is carried out with a stage at a second position, where immersion liquid is present. Alternatively, the apparatus has only one stage.

However, if the liquid remains stationary, temperature fluctuations can cause wave front disturbances in the projection beam and thus cause errors in the projected image. It has therefore been proposed to refresh the liquid periodically. However, using the seal described above, or an outlet in the vicinity of the seal to remove the liquid causes mechanical vibrations thereby disturbing the exposure. Also, the pressure involved in liquid refreshment is high and the projection system is highly sensitive to pressure variations which can cause deformations in the final element of the projection system and disturbances. Consequently the depth of liquid around the projection system should be kept constant.

The motion of the substrate relative to the projection system can generate a pressure gradient. In some circumstances this can lead to the liquid being swept from underneath the projection system. Unless the liquid is uniform under the projection system, or if gas bubbles are present under the projection system the accuracy of the exposure will be compromised.

If an error occurs in the apparatus such as failure of the seal or the substrate table is accidentally removed from beneath the projection system the liquid will be dispersed throughout the apparatus potentially damaging the apparatus unless the liquid is removed quickly. The liquid supply systems proposed above, particularly the one including the gas seal do not provide a fast enough way of evacuating the liquid.

Patent Abstracts of Japan relating to JP-A-63-157,419A discloses a fine pattern transfer apparatus in which a bellows is used to confine liquid to a space between a lens and a substrate.

EP 1 494 079A1 (prior art for novelty only) discloses an immersion lithographic apparatus and in particular flow arrangements to minimize disturbance.

EP 1 402 373A (also novelty only prior art) discloses an immersion lithographic projection apparatus using an aqueous solution having a pH of less than 7.

It is an object of the present invention to provide a system in which pressure fluctuations and/or temperature variations in the liquid are minimized without introducing unnecessary disturbances due to mechanical vibrations.

According to the invention there is provided a lithographic projection apparatus as defined in the appended claims.

In an embodiment of the invention an overflow is provided from the liquid reservoir formed by the immersion liquid and the excess liquid is removed to another location. The overflow can be used to maintain the liquid depth at a substantially constant level, thereby reducing pressure variations on the final element of the projection system due to a variable depth of liquid. As the fluid is being removed by an outlet other than that used in or around a gas seal mechanical vibrations will be reduced. Due to the presence of the overflow, liquid may be supplied at a higher flow rate than in conventional systems. The higher rate of liquid replacement ensures that the liquid doesn't heat up too much and also prevents contamination of the immersion liquid by the photoresist. According to an embodiment the overflow is the outlet liquid supply system. The apparatus further comprises an inlet for supplying liquid to the space between the final element of the projection system and the substrate, the overflow being arranged above the inlet to ensure the overflow effectively removes the liquid. The liquid is bounded by a barrier and an entrance to the overflow is positioned on the opposite side of the barrier. Thus only when the liquid is outside the boundary of the barrier is it removed by the overflow. The overflow is preferably arranged such that said liquid only flows into said overflow when said liquid flows over the top of said barrier. The overflow can be arranged so that it is at the same height as the top of the barrier or below the height of the barrier. For example, the barrier forms a ridge, the area of the ridge being not insignificant compared to the area of the final element of the projection system. For simplicity the barrier forms part of the liquid supply system. The liquid supply system referred to in this description is not limited simply to apparatus to supply fluid and can include elements to control the position, quantity, shape, flow rate or any other features of the fluid. The fluid continuously refreshed at a constant rate in order to reduce temperature variations.

In order to maintain the pressure above the liquid at a known level the space above the liquid is sealed with an airtight member. Furthermore the outlet can maintain the air pressure above the fluid at a constant level by, for example, providing a known suction force. Maintaining the gas pressure above the liquid at a constant level reduces the pressure variations on the projection system.

It is a further object of the invention to prevent sudden variations in the pressure of the liquid surrounding the final element of the projection system due to variations in the depth of the liquid.

In an embodiment of the invention the liquid is bounded by a barrier having a ridge having an area which is not insignificant compared to the area of the final element of the projection system. Thus the ridge should have an area such that as the volume of immersion liquid between the final element of the projection system and the substrate increases above the level of the ridge the depth of immersion liquid only increases very slowly. For simplicity the barrier is part of the liquid supply system.

According to another aspect of the invention there is provided a lithographic apparatus as specified in the opening paragraph wherein the radiation system provides a projection beam of radiation directed towards a target portion of the substrate, the liquid supply system comprising an outlet for removing liquid from the space between the final element of the projection system and the substrate and a seal member extending along at least a part of the boundary of said space between the final element of the projection system and the substrate table, the apparatus being characterized in that said seal member and said projection system form a capillary passage, said outlet being arranged to remove liquid at the end of at least part of said capillary passage.

The depth of fluid is therefore carefully controlled to the level defined by the capillary passage. The apparatus may further comprise an inlet for supplying liquid to said space, said inlet being adjacent to the inner circumference of said seal member and directed towards the target portion of the substrate. The fluid directly under the projection system, i.e. at the target portion of the substrate is thus refreshed continuously. This is the fluid most susceptible to overheating and contamination. The inlet is preferably a continuous groove around the projection system. The flow rate of the outlet is greater than that of the inlet so excess fluid does not accumulate and the depth of fluid remains at the level defined by the capillary passage.

It is a further object of the invention to prevent sudden variations in the pressure of the liquid surrounding the final element of the projection system due to variations in the depth of the liquid.

This and other objects are achieved according to a further aspect of the invention there is a lithographic projection apparatus as specified in the opening paragraph characterized in the said liquid is bounded by a barrier having a ridge having an area which is not insignificant compared to the area of the final element of the projection system. Thus the ridge should have an area such that as the volume of immersion liquid between the final element of the projection system and the substrate increases above the level of the ridge the depth of immersion liquid only increases very slowly. For simplicity the barrier is part of the liquid supply system.

It is a further object of the invention to provide a system in which the liquid can quickly and efficiently be removed in the event of a system error.

According to a further aspect of the invention the liquid supply system further comprises an inlet for supplying liquid to the space between the final element of the projection system and the substrate and means for connecting said inlet to a high vacuum source. If there is a system failure (e.g. the substrate table is suddenly removed) the inlet can therefore be used to remove the liquid from the apparatus thereby preventing liquid from leaking out over the apparatus and damaging delicate components. As the inlet is often closer to the lower end of the liquid volume removing liquid through the inlet can be a more effective method than simply using the outlet. The inlet therefore operates as an additional outlet speeding up extraction of the liquid in an emergency situation. A valve has been found to be a particularly suitable means for connecting the inlet to the high vacuum source. When a system failure occurs the valve quickly and simply connects the inlet to the high vacuum source. Optionally, the valve can be automatically operated upon a system failure.

It will be clear to the skilled person that any of the dependent claims can be made dependent on any of the other independent claims.

According to the prior art there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- supplying a liquid between a final element of a projection system used in said step of projection and said substrate through and inlet; and
- projecting the patterned beam of radiation onto a target portion of the layer of radiation-sensitive material.

According to a further aspect of the disclosure there is provided a device manufacturing method according to the method described above characterized by further providing an overflow.

According to a further aspect of the disclosure there is provided a device manufacturing method as described above characterized in that when the amount of fluid exceeds a given level an increase in the amount of fluid does not cause a significant change in the depth of fluid.

According to a further aspect of the disclosure there is provided a device manufacturing method as described above in which the projection beam is projected towards a target portion of the substrate, the liquid being supplied by and inlet and bounded by a seal member characterized in that the liquid flows out of the inlet and is directed towards the target portion of the substrate. The inlet is provided adjacent to the inner circumference of the seal member.

According to a further aspect of the disclosure there is provided a device manufacturing method described above characterized in that the depth of said liquid is controlled by capillary forces. The capillary forces are between a seal member and means for projection the patterned beam of radiation towards the substrate.

According to a further aspect of the disclosure there is provided a device manufacturing method as described above, the liquid being supplied by an inlet characterized by further providing means for connecting said inlet to a high vacuum source.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm).

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figures 2 and 3 depict a liquid supply system used in a prior art lithographic projection apparatus;
Figure 4 is a detail of a lithographic projection apparatus according to an embodiment of the invention;
Figure 5 is a detail of a lithographic projection apparatus according to another embodiment of the invention showing an overflow;
Figure 6 is a detail of an alternative lithographic projection apparatus according to an embodiment of the invention;
Figure 7 is a detail of an alternative lithographic projection apparatus according to an embodiment of the invention;
Figure 8 is a detail of an alternative lithographic projection apparatus according to an embodiment of the invention;
Figure 9 is a detail of an embodiment of the invention; and
Figure 10 depicts a liquid supply system according to another prior art lithographic projection apparatus.

In the Figures, corresponding reference symbols indicate corresponding parts.

### DETAILED DESCRIPTION

### Embodiment 1

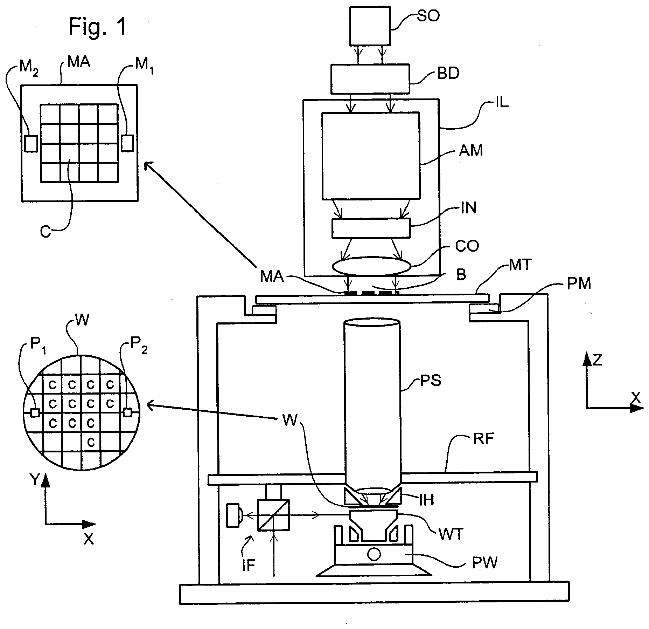

Figure 1 schematically depicts a lithographic apparatus according to one embodiment of the invention. The apparatus comprises:
- an illumination system (illuminator) IL configured to condition a radiation beam B (e.g. UV radiation or DUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

As shown in Figure 4 a liquid reservoir 10 between the projection lens and the substrate is bounded by a gas seal 16 forming an annulus around the projection lens. The seal, preferably a gas seal is formed by gas, e.g. air or synthetic air but preferably N₂ or another inert gas, provided under pressure via inlet 15 to the gap between seal member 12 and substrate and extracted via first outlet 14. The overpressure on the gas inlet 15, vacuum level on the first outlet 14 and geometry of the gap are arranged so that there is a high-velocity air flow inwards that confines the liquid. The distance between the gas inlet and outlet and the substrate W is small.

The liquid reservoir is supplied with liquid by inlets 21 and 22 and excess liquid is removed via outlet 14. The liquid reservoir extends above the bottom of the final element of the projection system PS to the level where the seal member 12 bounding the liquid reservoir and forming a barrier suddenly widens as shown in Figure 4. The top of the seal member forms a ridge, the area of which is of an area similar to or larger than the area of the bottom of the final element of the projection system PL. Therefore, if the quantity of liquid in the reservoir increases dramatically the depth of the reservoir 10 will not increase significantly as a large increase in the volume of immersion liquid over the large area of the top of the seal member 12 will not generate a large change in the depth of immersion fluid. The pressure variations due to a change in the depth of the reservoir will therefore be minimal.

### Embodiment 2

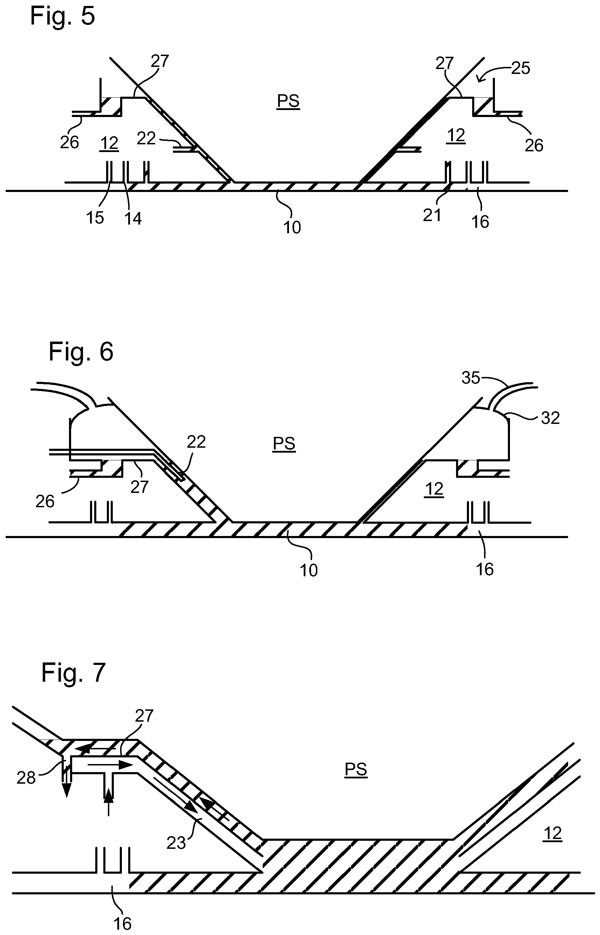

Figure 5 shows an alternative arrangement for the structure described in embodiment 1. An overflow structure 25 collects any excess liquid. The increase in depth of the liquid reservoir 10 due to an increase in the quantity of liquid is likely to be very small as a large amount of excess liquid can be accommodated in overflow structure 25. There is an annular shaped dyke 27 forming a barrier bounding the fluid and as the amount of liquid increases it flows over dyke 27 and into channel 26 which is an outlet, removing liquid from the reservoir 10. In this example the majority of the liquid is removed via channel 26 rather than outlet 14. The depth of fluid is thus controlled by the height of the dyke 27. As large amounts of liquid are not being removed via outlet 14 fewer vibrations are induced in the seal member 12 and the gas seal 16 functions more effectively. The flow rate of channel 26 should be sufficiently low to ensure that the gas content is small. Channel 26 is arranged above inlets 21 and 22 so the fluid overflows into channel 26.

### Embodiment 3

The embodiment shown in Figure 6 is the same as the embodiments above except for the aspects described below. There is just one inlet 22, separate from the seal member 12. Inlet 22 is formed between the projection system PS and the seal member 12 and fluid flows out from the inlet 22 at a height below that of the dyke 27, but above that of the bottom of the final element of the projection system PS. Fluid is supplied at a constant rate R, but, similarly to embodiment 3, the fluid is predominantly removed via channel 26 rather than gas outlet 14. The rate of substance removal through channel 26 is also a constant rate R. Seal 32 confines the gas around the reservoir 10 and prevents the moisture laden gas from pervading the whole apparatus, thereby damaging delicate parts and compromising the accuracy of measurements, e.g. interferometer readings. To keep the gas pressure above the reservoir 10 constant, and therefore the pressure at the final element of the projection system PS constant there is a passage 35 through the seal 32 through which gas can flow. The passage 35 leads outside the apparatus, thereby removing moisture laden air. The passage 35 should preferably have a low resistance allowing the gas to flow freely.

### Embodiment 4

In this embodiment fluid is supplied through concentric ring (i.e. annular) shaped inlet 23 arranged on the inner circumference of seal member 12 shown in Figure 7. Inlet 23 has a slit width of approximately 20 µm to 300 µm, preferably 150µm, is arranged at a distance of approximately 0.5mm from the substrate W and directs a channel of fluid towards the area directly under the projection system PS (i.e. the target portion) such that the fluid directly under the projection system PS is constantly refreshed. In this example the inlet 23 forms the inner edge of the seal member 12, but it could also be arranged so it was just adjacent to the inner circumference of the seal member 12. Alternatively inlet 23 could be a plurality of pipes arranged on the inner circumference of the seal member 12. As shown in Figure 7 a passage is formed between elements of the projection system PS and the seal member 12. Having circulated under the final element of the projection system PS the fluid flows through this passage and over the dyke 27 prior to being removed via outlet 28. However, unlike the earlier embodiments elements of the projection system PS, or another part of the apparatus bounds the upper level of the reservoir 10. No surface waves can therefore occur and static hydraulic pressures are limited resulting in a continuous uniform pressure on the projection system PS.

### Embodiment 5

The embodiment is the same as embodiment 4 except for the aspects described below. Inlet 33 is annular shaped with a diameter of approximately 50-100mm and a width of 20µm to 300µm, preferably 150µm. As shown in Figure 8 the inlet 33 can end before the bottom of the seal member 12 or can extend to the bottom of the seal member 12 or anywhere in between. Immersion liquid is supplied to inlet 33 through chamber 34 which has a greater cross-sectional area than inlet 33 to ensure that the chamber 34 provides a smaller restriction to flow.

In this embodiment the seal member 12 and the projection system PS are arranged such that the immersion fluid is held between the seal member 12 and the projection system PL by capillary forces at the level of dyke 27.

The edges of seal member 12 slope towards the projection system PS with an angle to the direction of propagation of the radiation beam B of approximately 45°. Dyke 27 intersects this slope and forms a broad ridge substantially perpendicular to the direction of propagation of the radiation beam B. The edges of projection system PS form a complimentary shape to the seal member 12 having a slope to the direction of propagation of the projection beam B of approximately 45° and also having a broad area perpendicular to the direction of propagation of the radiation beam B radially outwardly of the slope.

Outlet 38 is arranged beyond dyke 27 and has a greater flow rate than the rate of flow through inlet 33 to make sure that the amount of immersion fluid in reservoir 10 is controlled. Consequently some gas is also removed through outlet 38. Distance d₃ is governed by the actuation height of the seal member 12 and in this example is at least 2 mm. Distance d₃ should however be as large as possible to ensure that there is sufficient air flow for outlet 38. This arrangement of apparatus ensures that the depth of immersion fluid remains constant at the level of the projection system PS just above dyke 27.

To prevent the final element of the projection system PS from damage the distance d₁ between dyke 27 and the projection system PS is 2mm whereas the distance d₂ between the final element of the projection system PS and the substrate is greater than 2mm.

### Embodiment 6

In this embodiment the flow of fluid through the inlet 33 is controlled by valve 45 shown in Figure 9. During ordinary operation of the apparatus valve 45 allows fluid to flow freely through inlet 33. However, when an error is detected in the system or apparatus, for example accidental removal of the substrate W and substrate table WT or a servo error, valve 45 automatically connects inlet 33 to a high vacuum chamber (not shown in the accompanying drawings). The liquid can therefore be quickly removed from the reservoir. The valve 45 and associated vacuum chamber can be connected to other inlets e.g. inlets 21 and 23 shown in embodiments 4 to 7.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "reticle", "wafer" or "die" herein may be considered as synonymous with the more general terms "mask", "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The present invention can be applied to any immersion lithography apparatus, in particular, but not exclusively, those types mentioned above.

The descriptions above are intended to be illustrative, not limiting. Thus, it will be apparent to one skilled in the art that modifications may be made to the invention as described without departing from the scope of the claims set out below.
Clause 1: A lithographic projection apparatus comprising:
   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate; and
   - a liquid supply system for at least partly filling a space between the final element of said projection system and said substrate with a liquid to form a liquid reservoir,
   characterized by further comprising an overflow from said liquid reservoir.
Clause 2: A lithographic projection apparatus according to clause 1 further comprising an inlet for supplying liquid to said space wherein said overflow is arranged above said inlet.
Clause 3: A lithographic projection apparatus according to either clause 1 or clause 2 wherein said liquid is bounded by a barrier, an entrance to said overflow being positioned on the opposite side of the barrier.
Clause 4: A lithographic projection apparatus according to clause 3 wherein said overflow is arranged such that said liquid only flows into said overflow when said liquid flows over the top of said barrier.
Clause 5: A lithographic projection apparatus according to any one of the preceding clauses wherein said barrier forms part of the liquid supply system.
Clause 6: A lithographic projection apparatus according to any one of the preceding clauses wherein said barrier forms a ridge having an area which is not insignificant compared to the area of the final element of the projection system.
Clause 7: A lithographic projection apparatus according to any one of the preceding clauses wherein the space above said liquid is sealed with an airtight member.
Clause 8: A lithographic projection apparatus according to any one of the preceding clauses wherein said overflow maintains the pressure above said fluid at a constant level.
Clause 9: A lithographic projection apparatus according to any one of the preceding clauses further comprising a seal member extending along at least a part of the boundary of said space between the final element of said projection system and said substrate table, said seal member and said projection system forming a capillary passage, said overflow being arranged to remove liquid at the end of at least part of said capillary passage.
Clause 10: A lithographic projection apparatus according to any one of the preceding clauses further comprising a seal member extending along at least a part of the boundary of said space between the final element of said projection system and said substrate table and an inlet for supplying liquid to said space, said inlet being adjacent to the inner circumference of said seal member and directed towards the target portion of said substrate.
Clause 11: A lithographic projection apparatus comprising:
   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate; and
   - a liquid supply system for at least partly filling a space between the final element of said projection system and said substrate with a liquid,
   characterized in that said liquid is bounded by a barrier having a ridge having an area which is not insignificant compared to the area of the final element of the projection system.
Clause 12: A lithographic projection apparatus according to clause 11 wherein said barrier is part of said liquid supply system.
Clause 13: A lithographic projection apparatus according to either clause 11 or clause 12 further comprising a seal member extending along at least a part of the boundary of said space between the final element of said projection system and said substrate table and an outlet for removing liquid from said space, said seal member and said projection system forming a capillary passage, said outlet being arranged to remove liquid at the end of at least part of said capillary passage.
Clause 14: A lithographic projection apparatus according to any one of clauses 11 to 13 further comprising a seal member extending along at least a part of the boundary of said space between the final element of said projection system and said substrate table and an inlet for supplying liquid to said space, said inlet being adjacent to the inner circumference of said seal member and directed towards the target portion of said substrate.
Clause 15: A lithographic projection apparatus comprising:
   - a substrate table for holding a substrate;
   - a radiation system for providing a projection beam of radiation directed towards a target portion of said substrate;
   - a support structure for supporting patterning means, the patterning means serving to pattern the projection beam according to a desired pattern;
   - a projection system for projecting the patterned beam onto a target portion of the substrate; and
   - a liquid supply system for at least partly filling a space between the final element of said projection system and said substrate with a liquid, said liquid supply system comprising:
   - an inlet for supplying liquid to said space; and
   - a seal member extending along at least a part of the boundary of said space between the final element of said projection system and said substrate table,
   characterized in that said inlet is adjacent to the inner circumference of said seal member and is directed towards the target portion of the substrate.
Clause 16: A lithographic projection apparatus according to clause 15 wherein said liquid supply system is arranged such that a passage is formed between an element of the projection system and said seal member for the flow of liquid towards an outlet.
Clause 17: A lithographic projection apparatus according to clause 16 wherein said outlet is at the end of said passage.
Clause 18: A lithographic projection apparatus according to any one of clauses 15 to 17 further comprising a chamber, through which said liquid is supplied to said inlet, said chamber having a larger cross-sectional area than the cross sectional area of said inlet.
Clause 19: A lithographic projection apparatus according to any one of clauses 15 to 18 further comprising an outlet for removing liquid from said space, said seal member and said projection system forming a capillary passage, said outlet being arranged to remove liquid at the end of at least part of said capillary passage.
Clause 20: A lithographic projection apparatus according to any one of clauses 15 to 19 further comprising an overflow.
Clause 21: A lithographic projection apparatus comprising:
   - a substrate table for holding a substrate;
   - a radiation system for providing a projection beam of radiation directed towards a target portion of said substrate;
   - a support structure for supporting patterning means, the patterning means serving to pattern the projection beam according to a desired pattern;
   - a projection system for projecting the patterned beam onto a target portion of the substrate; and
   - a liquid supply system for at least partly filling a space between the final element of said projection system and said substrate with a liquid, said liquid supply system comprising:
   - a seal member extending along at least a part of the boundary of said space between the final element of said projection system and said substrate table,
   - an outlet for removing liquid from said space,
   characterized in that said seal member and said projection system form a capillary passage, said outlet being arranged to remove liquid at the end of at least part of said capillary passage.
Clause 22: A lithographic projection apparatus according to clause 21 further comprising an inlet for supplying liquid to said space wherein the flow rate of said outlet is greater than the flow rate of said inlet.
Clause 23: A lithographic projection apparatus according to either clause 21 or clause 22 further comprising an inlet for supplying liquid to said space, said inlet being adjacent to the inner circumference of said seal member and directed towards the target portion of the substrate.
Clause 24: A lithographic projection apparatus according to any one of clauses 21 to 23 further comprising an inlet for supplying liquid to said space, said inlet being adjacent to the inner circumference of said seal member and directed towards the target portion of said substrate
Clause 25: A lithographic projection apparatus according to any one of clauses 21 to 25 further comprising an overflow.
Clause 26: A lithographic projection apparatus comprising:
   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate; and
   - a liquid supply system for at least partly filling a space between the final element of said projection system and said substrate with a liquid, said liquid supply system comprising an inlet for supplying liquid to said space,
   characterized by further comprising means for connecting said inlet to a high vacuum source.
Clause 27: A lithographic projection apparatus according to clause 26 wherein said inlet operates as an outlet when connected to said high vacuum source.
Clause 28: A lithographic projection apparatus according to either clause 26 or clause 27 wherein said means for connecting said inlet to a high vacuum source is automatically operated upon a system failure.
Clause 29: A lithographic projection apparatus according to any one of the preceding clauses wherein said liquid reservoir covers a smaller area than said substrate.

## Claims

1. A lithographic apparatus comprising:
a substrate table (WT) for holding a substrate (W);
a projection system (PS) for projecting a radiation beam (B) having a patterned cross-section onto a target portion (C) of the substrate (W); and
a liquid supply system for at least partly filling a space between a final element of the projection system (PS) and the substrate (W) with a liquid to form a liquid reservoir (10); and
a seal member (12) extending along at least a part of the boundary of the space between the projection system (PS) and the substrate table (WT), wherein:
the seal member (12) comprises
a dyke (27) forming a barrier bounding the liquid and arranged to control the depth of the liquid, and
an outlet (26, 28, 38) for removing liquid which, during use, flows over the dyke into the outlet.

2. The lithographic apparatus of claim 1, wherein
the dyke (27) intersects a slope formed by the edges of the seal member (12),
and wherein
the dyke (27) forms a ridge on the top of the seal member (12) and the ridge is perpendicular to the direction of propagation of the radiation beam.

3. The lithographic apparatus of claim 2, wherein the edges of the seal member (12) slope towards the projection system (PS) with an angle to the direction of propagation of the radiation beam of 45 degrees.

4. A lithographic apparatus according to claim 1, wherein the dyke (27) is annular.

5. The lithographic apparatus of claim 4, wherein the outlet (26, 28, 38) is aranged radially outwards of the dyke (27).

6. The lithographic apparatus according to any of the preceding claims, further comprising an overflow (25) to collect excess liquid.

7. The lithographic apparatus according to any of the preceding claims, further comprising an inlet (33) for supplying liquid to the space wherein the outlet (38) has a greater flow rate than the rate of flow through the inlet (33) to make sure that the amount of the liquid in the reservoir (10) is controlled.

## Patentansprüche

1. Ein lithographisches Gerät, das Folgendes beinhaltet:
einen Substrattisch (WT) zum Halten eines Substrats (W);
ein Projektionssystem (PS) zum Projizieren eines Strahlungsstrahls (B) mit einem gemusterten Querschnitt auf einen Zielabschnitt (C) des Substrats (W); und
ein Flüssigkeitszufuhrsystem, um einen Raum zwischen einer Endkomponente des Projektionssystems (PS) und dem Substrat (W) mindestens teilweise mit einer Flüssigkeit zu füllen, um ein Flüssigkeitsreservoir (10) zu bilden; und
ein Dichtungselement (12), das sich entlang mindestens eines Teils der Grenze des Raums zwischen dem Projektionssystem (PS) und dem Substrattisch (WT) erstreckt, wobei:
das Dichtungselement (12) Folgendes beinhaltet:
einen Damm (27), der eine die Flüssigkeit begrenzende Barriere bildet und eingerichtet ist, um die Tiefe der Flüssigkeit zu regulieren, und
einen Auslass (26, 28, 38) zum Entfernen von Flüssigkeit, die während der Verwendung über den Damm in den Auslass fließt.

2. Lithographisches Gerät gemäß Anspruch 1, wobei
der Damm (27) eine von den Kanten des Dichtungselements (12) gebildete Neigung schneidet,
und wobei
der Damm (27) auf dem Dichtungselement (12) einen Rücken bildet und der Rücken zu der Ausbreitungsrichtung des Strahlungsstrahls senkrecht ist.

3. Lithographisches Gerät gemäß Anspruch 2, wobei sich die Kanten des Dichtungselements (12) mit einem Winkel zur Ausbreitungsrichtung des Strahlungsstrahls von 45 Grad in Richtung des Projektionssystems (PS) neigen.

4. Lithographisches Gerät gemäß Anspruch 1, wobei der Damm (27) ringförmig ist.

5. Lithographisches Gerät gemäß Anspruch 4, wobei der Auslass (26, 28, 38) radial außerhalb des Damms (27) eingerichtet ist.

6. Lithographisches Gerät gemäß einem der vorhergehenden Ansprüche, das ferner einen Überlauf (25) zum Sammeln überschüssiger Flüssigkeit beinhaltet.

7. Lithographisches Gerät gemäß einem der vorhergehenden Ansprüche, das ferner einen Einlass (33) zum Zuführen von Flüssigkeit in den Raum beinhaltet, wobei der Auslass (38) eine größere Durchflussrate als die Rate des Durchflusses durch den Einlass (33) aufweist, um sicherzustellen, dass die Menge der Flüssigkeit in dem Reservoir (10) reguliert ist.

## Revendications

1. Un appareil lithographique comprenant :
une table porte-substrat (WT) destinée à porter un substrat (W) ;
un système de projection (PS) destiné à projeter un faisceau de rayonnement (B) présentant une coupe transversale à motif sur une portion cible (C) du substrat (W) ; et
un système d'amenée de liquide destiné à remplir au moins partiellement un espace entre un élément final du système de projection (PS) et le substrat (W) avec un liquide afin de former un réservoir de liquide (10) ; et
un élément d'étanchéité (12) s'étendant le long d'au moins une partie de la délimitation de l'espace entre le système de projection (PS) et la table porte-substrat (WT), dans lequel :
l'élément d'étanchéité (12) comprend
une digue (27) formant une barrière retenant le liquide et agencée afin de contrôler la profondeur du liquide, et
une sortie (26, 28, 38) destinée à retirer du liquide qui, au cours de l'utilisation, s'écoule par-dessus la digue jusque dans la sortie.

2. L'appareil lithographique de la revendication 1, dans lequel
la digue (27) coupe une inclinaison formée par les bords de l'élément d'étanchéité (12),
et dans lequel
la digue (27) forme une arête sur le haut de l'élément d'étanchéité (12) et l'arête est perpendiculaire à la direction de propagation du faisceau de rayonnement.

3. L'appareil lithographique de la revendication 2, dans lequel les bords de l'élément d'étanchéité (12) sont inclinés vers le système de projection (PS) avec un angle par rapport à la direction de propagation du faisceau de rayonnement de 45 degrés.

4. Un appareil lithographique selon la revendication 1, dans lequel la digue (27) est annulaire.

5. L'appareil lithographique de la revendication 4, dans lequel la sortie (26, 28, 38) est agencée radialement vers l'extérieur de la digue (27).

6. L'appareil lithographique selon n'importe lesquelles des revendications précédentes, comprenant en sus un trop-plein (25) afin de collecter un excès de liquide.

7. L'appareil lithographique selon n'importe lesquelles des revendications précédentes, comprenant en sus une entrée (33) pour amener du liquide jusqu'à l'espace, la sortie (38) ayant un débit supérieur au débit à travers l'entrée (33) afin de s'assurer que la quantité de liquide dans le réservoir (10) est contrôlée.
